# EUROPÄISCHE PATENTSCHRIFT

(11) **EP 0 337 371 B1**
(45) Veröffentlichungstag und Bekanntmachung des Hinweises auf die Patenterteilung: **22.06.1994**
(21) Anmeldenummer: 89106357.0
(22) Anmeldetag: 11.04.1989
(51) Int. Cl.: H03B 5/18

(54) **Mikrowellenoszillator**
Microwave oscillator
Oscillateur à micro-ondes

(30) Priorität: 15.04.1988 DE 3812669
(43) Veröffentlichungstag der Anmeldung: 18.10.1989
(73) Patentinhaber: SIEMENS AKTIENGESELLSCHAFT, 80333 München (DE)
(72) Erfinder: Otremba, Klaus, Ing.(grad), D-8000 München 60 (DE); Sartorius, Volker, Dipl.-Ing., D-8039 Puchheim (DE)

(56) Entgegenhaltungen:
- EP-A- 0 137 281
- US-A- 4 588 964
- US-A- 4 628 283
- US-A- 4 630 004
- PATENT ABSTRACTS OF JAPAN, Band 11, Nr. 108 (E-495)[2555], 4. April 1987; & JP-A-61 255 102 (FUJITSU LTD) 12-11-1986

## Beschreibung

Die Erfindung bezieht sich auf einen Mikrowellenoszillator mit einem, mit einer elektrischen Schaltung elektromagnetisch gekoppelten dielektrischen Resonator.

Aus die Dokumente DE 29 31 428 C2 und sind US-A-4 628 283 Mikrowellenoszillatorer mit einem Hohlraumresonator und mit einem mit dem Hohlraumresonator gekoppelten Festkörper-Bauelement bekannt. Das Festkörper-Bauelement ist dabei auf einer von dem topfförmigen Resonator überdeckten metallischen Grundplatte angeordnet und mit seinem Masseanschluß leitend auf einem in der Grundplatte befestigten Schraubfuß aufgebracht.

Bei Oszillatoren mit einem dielektrischen Resonator sind die Eigenschaften von der Luftfeuchte abhängig, da Resonanzfrequenz und Güte dielektrischer Resonatoren u.a. Funktionen der sie umgebenden Luftfeuchte sind.

Der Erfindung liegt die Aufgabe zugrunde, einen Oszillator mit einem dielektrischen Resonator zu schaffen, dessen Eigenschaften unabhängig von der Luftfeuchte sind und der eine Herstellung ermöglicht, bei der der dielektrische Resonator erst am Ende des Fertigungsablaufes dem Oszillator mechanisch fest zugeordnet wird.

Diese Aufgabe wir gemäß der Erfindung mit den Merkmalen des Anspruchs 1 gelöst.

Vorteilhafte Ausgestaltungen und Weiterbildungen des Erfindungsgegenstandes sind in den Unteransprüchen angegeben.

Nachstehend wird die Erfindung anhand von in der Zeichnung dargestellten Ausführungsbeispielen näher erläutert.

Es zeigen
- Figur 1: einen Mikrowellenoszillator mit einem hermetisch dichten dielektrischen Resonator,
- Figuren 2 bis 5: in Teildarstellungen den Mikrowellenoszillator mit unterschiedlicher Ausbildung des hermetisch dichten dielektrischen Resonators und
- Figuren 6 bis 9: verschiedene Ausführungsformen der Ankopplung des dielektrischen Resonators an die elektrische Schaltung auf der Schichtschaltungsplatte.

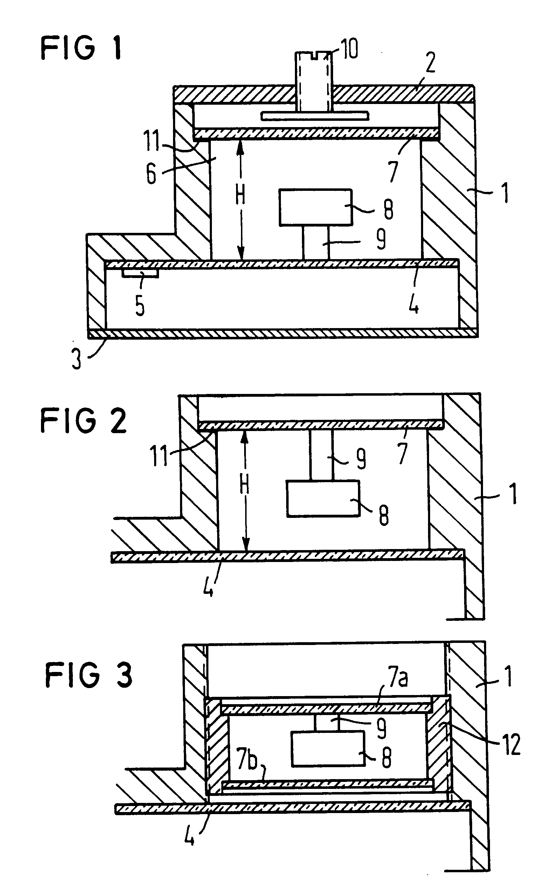

Fig. 1 zeigt einen Mikrowellenoszillator mit hermetisch dichtem dielektrischen Resonator im Querschnitt. Dabei ist ein beidseitig offenes Metallgehäuse 1 vorgesehen, das mit Metalldeckeln 2,3 abschließbar ist. Das Metallgehäuse 1 ist stufenförmig abgesetzt, so daß ein unterer Bereich größeren Querschnitts und ein oberer Bereich kleineren Querschnitts gebildet wird. In den unteren Bereich ist eine Schichtschaltungsplatte 4 eingesetzt, die an ihrer dem oberen Bereich des Metallgehäuses zugekehrten Rückseite ganzflächig metallisiert ist und auf der Vorderseite die Elemente der aktiven Oszillatorschaltung, beispielsweise den Transistor 5 sowie die Koppelorgane trägt, die durch Öffnungen in der rückseitigen Metallisierung der Schichtschaltungsplatte 4 die elektromagnetische Verkopplung mit einem im oberen Bereich des Metallgehäuses angeordneten dielektrischen Resonator 8 ermöglichen. Die Schichtschaltungsplatte 4 liegt mit ihrer metallisierten Rückseite auf Absätzen der Innenwand des Metallgehäuses an und ist mit diesem verlötet. Der dielektrische Resonator 8 befindet sich in einem beispielsweise zylindrischen Hohlraum 6, der seitlich von den Wänden des Metallgehäuses 1 umschlossen und hinsichtlich der Grundseiten einerseits von der Schichtschaltungsplatte 4 und andererseits von einer Quarzglasplatte 7 abgeschlossen ist, die im Abstand H zur Schichtschaltungsplatte 4 auf einem umflaufenden stufenförmigen Absatz der Innenwand des Metallgehäuses 1 aufliegt und mit diesem verklebt ist (Klebestelle 11). Somit wird durch die mit dem Metallgehäuse verlötete Schichtschaltungsplatte 4 und die mit dem Metallgehäuse verklebte Quarzglasplatte 7 ein hermetisch dichter Hohlraum für den dielektrischen Resonator 8 geschaffen. Der dielektrische Resonator 8 ist über einen Glasstift 9 mit der Schichtschaltungsplatte 4 verklebt. Ferner ist ein Element 10 zur Feinabstimmung vorgesehen, das aus einem im oberen Metalldeckel 2 geführten Gewindestift und einem an seiner Stirnseite angebrachten, z. B. metallischen Teller besteht. Dieser wird im Hohlraum zwischen Metalldeckel 2 und Quarzglasplatte 7 bewegt und beeinflußt damit die Resonanzfrequenz des dielektrischen Resonators 8.

Fig. 2 zeigt in einer Teildarstellung einen Mikrowellenoszillator ähnlich dem nach Fig. 1. Unterschiedlich ist hierbei, daß der dielektrische Resonator 8 über den Glasstab 9 mit der Glasplatte 7 verklebt ist. Der Vorteil dieser Anordnung anstelle der Befestigung an der Schichtschaltungsplatte besteht darin, daß eine saubere Bearbeitung und Reinigung des dielektrischen Resonators zum Frequenzabgleich, eine Einstellung der Kopplung durch Änderung der Höhe H sowie eine gute Kontrolle der Klebestelle möglich sind.

Fig. 3 zeigt in einer Teildarstellung eine Ausführungsform einer Halterung und Feuchtabdichtung für den dielektrischen Resonator, bei der der dielektrische Resonator in einem hermetisch dichten Gehäuse montiert ist, das aus einem in den oberen Bereich des Metallgehäuses 1 einsetzbaren metallischen Gewindering 12 und beiderseits auf dessen Öffnungen aufgesetzten Glasplatten 7a und 7b besteht. Der Vorteil dieser Anordnung besteht in einer einfachen Bearbeitung und Reinigung des dielektrischen Resonators vor dem Verschließen des Gehäuses, optimalen Prüfmöglichkeiten hinsichtlich der Dichtigkeit sowie einer einfachen Einstellung der elektrischen Kopplung und einfachen Reparaturmöglichkeit des Oszillators.

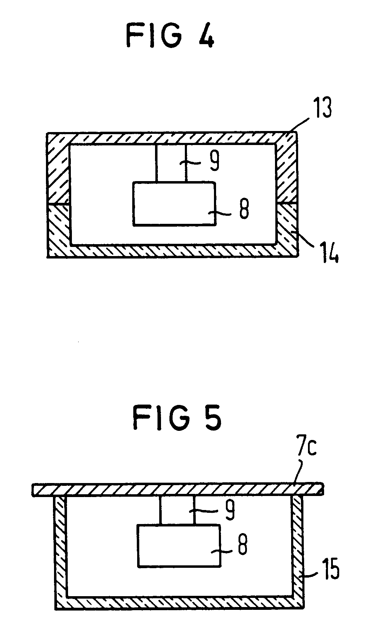

Die Figuren 4 und 5 zeigen spezielle Formen eines hermetisch dichten Gehäuses für den dielektrischen Resonator, die auch eine elektrische Verkopplung durch die Zylinderwand gestatten. Unterschiedlich zu den bisher beschriebenen Ausführungsformen, die in der Regel für eine Kopplung durch den Boden des Gehäuses gedacht sind, besteht hierbei das Gehäuse jeweils aus Glas, wobei beim Ausführungsbeispiel nach Fig. 4 zwei wannenförmige Halbschalen 13,14 mit ihren Stirnseiten aufeinanderliegend angeordnet sind und beim Ausführungsbeispiel nach Fig. 5 das Gehäuse aus einem topfförmigen Glasbehälter 15 mit einer aufgesetzten Deckplatte 7c besteht. Der dielektrische Resonator 8 ist hierbei ebenfalls über den Glasstab 9 an der Oberseite des Gehäuses befestigt.

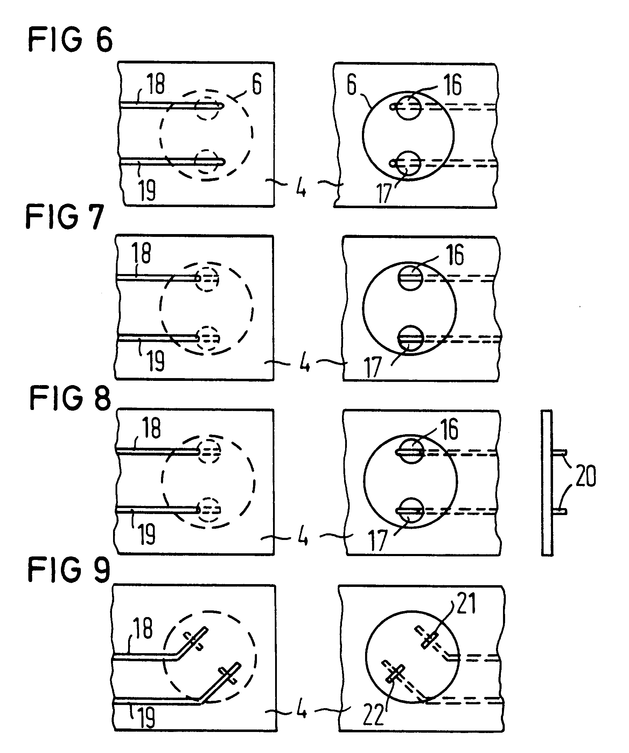

Die Figuren 6 bis 9 zeigen in Teildarstellungen verschiedene Ausführungsformen der Ankopplung des dielektrischen Resonators an die elektrische Schaltung auf der Schichtschaltungsplatte. Dabei ist jeweils derjenige Bereich der Schichtschaltungsplatte 4 in Vorder- und Rückansicht dargestellt, der im Bereich des den dielektrischen Resonator enthaltenden Hohlraumes liegt. Die Kontur des Hohlraumes ist dabei als strichliert gezeichneter Kreis (Vorderseite) bzw. geschlossener Kreis (Rückseite) dargestellt. Im Bereich der Koppelorgane auf der Vorderseite der Schichtschaltungsplatte 4 sind auf deren ganzflächig metallisierter Rückseite Ausnehmungen 16,17 angebracht. Über diese Ausnehmungen 16,17 erstrecken sich auf der gegenüberliegenden, vorderen Seite der Schichtschaltungsplatte 4 Leiterbahnen 18,19, die dann zur metallisierten Rückseite der Schichtschaltungsplatte 4 durchkontaktiert und an Masse geführt sind (Fig. 6). Abweichend hiervon sind beim Ausführungsbeispiel nach Fig. 7 die durchkontaktierten Endbereiche der Mikrostripleitungen 18,19 als Koppelschleife und beim Ausführungsbeispiel nach Fig. 8 als in den Hohlraum 6 hineinragende Drahtbügel 20 ausgebildet.

Fig. 9 zeigt eine Ankopplung des dielektrischen Resonators in Form einer Schlitzkopplung. Hierzu sind die Endbereiche der Mikrostripleitungen 18,19 so abgewinkelt, daß sie senkrecht zu schlitzförmigen Ausnehmungen 21,22 auf der gegenüberliegenden metallisierten Rückseite der Schichtschaltungsplatte 4 verlaufen.

Eine bevorzugte Ausführungsform stellt dabei die Ankopplung nach Fig. 7 dar, weil einerseits eine feste Kopplung mit dem dielektrischen Resonator möglich ist und andererseits die Überkopplung von einer Koppelstelle zur anderen relativ gering ist. Um solche störend wirkenden Überkopplungen zwischen den einzelnen Koppelstellen ganz zu vermeiden, ist es vorteilhaft, zwischen den einzelnen Koppelstellen auf der Bauteileseite der Schichtschaltungsplatte 4 schirmende Trennwände einzufügen. Hierzu kann der Raum zwischen Schichtschaltungsplatte 4 und unterem Metalldekkel 3 in einzelne Kammern aufgeteilt werden, in die gegebenenfalls die einzelnen Abschnitte einer mehrfach unterteilten Schichtschaltungsplatte eingesetzt werden.

Die erfindungsgemäßen Ausführungsformen des Mikrowellenoszillators gestatten das Einstellen der elektromagnetischen Kopplung zwischen dielektrischem Resonator und einer elektrischen Schaltung durch geometrische Änderungen der Koppelorgane oder durch mechanische Abstandsänderungen zwischen dielektrischem Resonator und Schaltung. Der dielektrische Resonator ist dabei sehr wirkungsvoll und beständig vor Luftfeuchte geschützt. Die Verbindungsstellen (Lötflächen und Klebestellen) sind gut kontrollierbar. Bei einer solchen Ausgestaltung des dielektrischen Resonators kann seine mechanische Zuordnung zur elektrischen Schaltung während der Endprüfung erfolgen, so daß eine anschließend notwendige zuverlässige Reinigung des dielektrischen Resonators möglich ist.

## Patentansprüche

1. Mikrowellenoszillator mit einem, mit einer elektrischen Schaltung elektromagnetisch gekoppelten dielektrischen Resonator, der in einem hermetisch dichten Hohlraum innerhalb eines die elektrische Schaltung aufnehmenden Metallgehäuses, dessen Seitenwände den Hohlraum seitlich umschließen, in entsprechender Lage zu Koppelelementen auf einer die elektrische Schaltung tragenden, einseitig ganzflächig metallisierten, den Hohlraum hinsichtlich einer Grundseite abschließenden Schichtschaltungsplatte (4) angeordnet ist, dadurch **gekennzeichnet**, daß der Hohlraum (6) hinsichtlich der zweiten Grundseite von einer Glasplatte (7) abgeschlossen ist, daß der dielektrische Resonator (8) über einen Glasstift (9) an einer der den Hohlraum (6) abschließenden Grundflächen befestigt ist und daß ein Feinabstimmelement (10) vorgesehen ist, das in eine Bohrung der metallischen Abdeckung (2) des Metallgehäuses (1) eingesetzt und zwischen der metallischen Abdeckung (2) und der Abdeckung (7) des den dielektrischen Resonator (8) aufnehmenden Hohlraums (6) angeordnet ist.

2. Mikrowellenoszillator nach Anspruch 1, dadurch **gekennzeichnet**, daß die Glasplatte (7) mit den Gehäuseseitenwänden verklebt ist.

3. Mikrowellenoszillator nach Anspruch 2, dadurch **gekennzeichnet**, daß die Innenseiten des Metallgehäuses (1) in einem der Höhe des Hohlraums (6) entsprechenden Abstand derart stufenförmig abgesetzt sind, daß Schichtschaltungsplatte (4) und Glasplatte (7) auf den so gebildeten Absätzen aufliegen.

4. Mikrowellenoszillator nach Anspruch 1, dadurch **gekennzeichnet**, daß der dielektrische Resonator (8) innerhalb eines separaten hermetisch dichten Gehäuses angeordnet ist, das in das Metallgehäuse eingesetzt ist.

5. Mikrowellenoszillator nach Anspruch 4, dadurch **gekennzeichnet**, daß das Gehäuse aus einem Gewindering (12) und beidseitig aufgesetzten Glasplatten (7a, 7b) besteht.

6. Mikrowellenoszillator nach Anspruch 4, dadurch **gekennzeichnet**, daß das Gehäuse aus zwei mit ihren Stirnseiten aufeinanderliegenden wannenförmigen Halbschalen (13, 14) aus Glas besteht.

7. Mikrowellenoszillator nach Anspruch 4, dadurch **gekennzeichnet**, daß das Gehäuse aus einem topfförmigen Glasbehälter (15) und einer aufgesetzten Deckplatte (7c) besteht.

8. Mikrowellenoszillator nach einem der Ansprüche 1 bis 7, dadurch **gekennzeichnet**, daß das Metallgehäuse (1) an seinen Stirnseiten offen und in seiner Höhe stufenförmig abgesetzt ist derart, daß der untere Bereich den Querschnitt der einzusetzenden Schichtschaltungsplatte (4) und der obere, den Hohlraum (6) für den dielektrischen Resonator (8) bildende Bereich einen kleineren Querschnitt aufweist und beide Stirnseiten des Metallgehäuses (1) mit Metalldeckeln (2, 3) abschließbar sind.

9. Mikrowellenoszillator nach einem der Ansprüche 1 bis 8, dadurch **gekennzeichnet**, daß die Ankopplung des dielektrischen Resonators (8) an die elektrische Schaltung über durchkontaktierte Mikrostripleitungen (18, 19) erfolgt.

10. Mikrowellenoszillator nach einem der Ansprüche 1 bis 8, dadurch **gekennzeichnet**, daß die Ankopplung des dielektrischen Resonators (8) an die elektrische Schaltung über eine durchkontaktierte Koppelschleife erfolgt.

11. Mikrowellenoszillator nach einem der Ansprüche 1 bis 8, dadurch **gekennzeichnet**, daß die Ankopplung des dielektrischen Resonators (8) die elektrische Schaltung über Drahtbügel (20) erfolgt.

12. Mikrowellenoszillator nach einem der Ansprüche 1 bis 8, dadurch **gekennzeichnet**, daß die Ankopplung des dielektrischen Resonators (8) an die elektrische Schaltung über eine Schlitzkopplung-Mikrostrip (18, 19; 21, 22) auf der Bauteileseite der Schichtschaltungsplatte (4) erfolgt.

## Claims

1. Microwave oscillator having a dielectric resonator which is electromagnetically coupled to an electrical circuit and is arranged in a hermetically sealed cavity inside a metal housing which accommodates the electrical circuit and whose side walls enclose the cavity at the sides in a corresponding position to coupling elements on a film-circuit board (4) which carries the electrical circuit, is metallized over the complete area on one side and terminates the cavity with respect to a base side, characterized in that the cavity (6) is terminated by a glass plate (7) with respect to the second base side, in that the dielectric resonator (8) is attached via a glass pin (9) to one of the base surfaces which terminates the cavity (6), and in that a fine tuning element (10) is provided which is inserted into a hole in the metallic cover (2) of the metal housing (1) and is arranged between the metallic cover (2) and the cover (7) of the cavity (6) which accommodates the dielectric resonator (8).

2. Microwave oscillator according to Claim 1, characterized in that the glass plate (7) is bonded to the housing side walls.

3. Microwave oscillator according to Claim 2, characterized in that the inner sides of the metal housing (1) are offset in the form of a step at a distance corresponding to the height of the cavity (6) in such a manner that the film-circuit board (4) and glass plate (7) rest on the steps thus formed.

4. Microwave oscillator according to Claim 1, characterized in that the dielectric resonator (8) is arranged inside a separate hermetically sealed housing which is inserted into the metal housing.

5. Microwave oscillator according to Claim 4, characterized in that the housing comprises a threaded ring (12) and glass plates (7a, 7b) fitted on both sides.

6. Microwave oscillator according to Claim 4, characterized in that the housing comprises two glass half shells (13, 14) which are in the form of troughs and whose ends rest on one another.

7. Microwave oscillator according to Claim 4, characterized in that the housing comprises a pot-shaped glass container (15) and a covering panel (7c) placed on it.

8. Microwave oscillator according to one of Claims 1 to 7, characterized in that the metal housing (1) is open at its ends and is offset in the form of a step in its height in such a manner that the lower region has the cross-section of the film-circuit board (4) to be inserted and the upper region, which forms the cavity (6) for the dielectric resonator (8), has a small cross-section, and both ends of the metal housing (1) can be terminated by metal covers (2, 3).

9. Microwave oscillator according to one of Claims 1 to 8, characterized in that the dielectric resonator (8) is coupled to the electrical circuit via through-plated micro-striplines (18, 19).

10. Microwave oscillator according to one of Claims 1 to 8, characterized in that the dielectric resonator (8) is coupled to the electrical circuit via a through-plated coupling loop.

11. Microwave oscillator according to one of Claims 1 to 8, characterized in that the dielectric resonator (8) is coupled to the electrical circuit via a wire bracket (20).

12. Microwave oscillator according to one of Claims 1 to 8, characterized in that the dielectric resonator (8) is coupled to the electrical circuit via a slot-coupling microstrip (18, 19; 21, 22) on the component side of the film-circuit board (4).

## Revendications

1. Oscillateur à micro-ondes comportant un résonateur diélectrique couplé électromagnétiquement à un circuit électrique et qui est disposé dans une cavité hermétiquement fermée, à l'intérieur d'un boîtier métallique qui loge le circuit électrique et dont les parois latérales entourent latéralement la cavité, dans une position correspondante par rapport à des éléments de couplage situés sur une plaquette à circuits imprimés en forme de couche (4) qui porte le circuit électrique, est métallisée entièrement sur l'une de ses faces et ferme la cavité au niveau d'un côté de base, caractérisé par le fait que la cavité (6) est fermée au niveau du second côté de base, par une plaque de verre (7), que le résonateur diélectrique (8) est fixé par l'intermédiaire d'une tige de verre (9) à l'une des surfaces de base qui ferment la cavité (6), et qu'il est prévu un élément de réglage d'accord précis (10), qui est inséré dans un perçage de l'élément de recouvrement métallique (2) du boîtier métallique (1) et est disposé entre l'élément de recouvrement métallique (2) et le couvercle (7) de la cavité (6) qui loge le résonateur diélectrique (8).

2. Oscillateur à micro-ondes suivant la revendication 1, caractérisé par le fait que la plaque de verre (7) est collée aux parois latérales du boîtier.

3. Oscillateur à micro-ondes suivant la revendication 2, caractérisé par le fait que les faces intérieures du boîtier métallique (1) sont étagées avec une forme échelonnée à une distance qui correspond à la hauteur de la cavité (6) de sorte que la plaquette à circuits imprimés en forme de couche (4) et la plaque de verre (7) sont en appui sur les parties étagées ainsi formées.

4. Oscillateur à micro-ondes suivant la revendication 1, caractérisé par le fait que le résonateur diélectrique (8) est disposé dans un boîtier fermé de façon hermétique, qui est inséré dans le boîtier métallique.

5. Oscillateur à micro-ondes suivant la revendication 4, caractérisé par le fait que le boîtier est constitué par une bague filetée (12) et des plaques de verre (7a, 7b) disposées sur ses deux côtés.

6. Oscillateur à micro-ondes suivant la revendication 4, caractérisé par le fait que le boîtier est constitué par deux demi-coques en forme de cuvettes en verre (13, 14), qui s'appliquent l'une sur l'autre par leurs faces frontales.

7. Oscillateur à micro-ondes suivant la revendication 4, caractérisé par le fait que le boîtier est constitué par un récipient en verre en forme de pot (15) et une plaque de fermeture (7c) posée sur ce récipient.

8. Oscillateur à micro-ondes suivant l'une des revendications 1 à 7, caractérisé par le fait que le boîtier métallique (1) est ouvert sur ses faces frontales et est étagé avec une forme étagée en hauteur de sorte que la partie inférieure possède la section transversale de la plaquette à circuits imprimés en forme de couche (4), qui doit être insérée, et que la partie supérieure, qui forme la cavité (6) pour le résonateur diélectrique (8), possède une section transversale plus petite et que les deux faces frontales du boîtier métallique (1) peuvent être fermées par des couvercles métalliques (2, 3).

9. Oscillateur à micro-ondes suivant l'une des revendications 1 à 8, caractérisé par le fait que l'accouplement du résonateur diélectrique (8) au circuit électrique s'effectue par l'intermédiaire de lignes en forme de microbandes (18, 19), raccordées par des contacts traversants.

10. Oscillateur à micro-ondes suivant l'une des revendications 1 à 8, caractérisé par le fait que l'accouplement du résonateur diélectrique (8) au circuit électrique s'effectue par l'intermédiaire d'une boucle de couplage raccordée par des contacts traversants.

11. Oscillateur à micro-ondes suivant l'une des revendications 1 à 8, caractérisé par le fait que l'accouplement du résonateur diélectrique (8) au circuit électrique s'effectue par l'intermédiaire d'étriers formés d'un fil (20).

12. Oscillateur à micro-ondes suivant l'une des revendications 1 à 8, caractérisé par le fait que l'accouplement du résonateur diélectrique (8) au circuit électrique est réalisé par l'intermédiaire d'une microbande de couplage à fente (18, 19; 21, 22) sur le côté des composants de la plaquette à circuits imprimés en forme de couche (4).
